# EUROPÄISCHE PATENTSCHRIFT

(11) **EP 1 348 132 B1**
(45) Veröffentlichungstag und Bekanntmachung des Hinweises auf die Patenterteilung: **03.06.2009**
(21) Anmeldenummer: 02726971.1
(22) Anmeldetag: 04.01.2002
(51) Int. Cl.: G01R 1/20, H01C 3/02

(54) **ELEKTRISCHER WIDERSTAND FÜR DIE MESSUNG VORZUGSWEISE HOCHFREQUENTER WECHSELSTRÖME**
ELECTRICAL RESISTANCE FOR THE MEASUREMENT OF PREFERABLY HIGH FREQUENCY ALTERNATING CURRENTS
RESISTANCE ELECTRIQUE PERMETTANT LA MESURE DE PREFERENCE DE COURANTS ALTERNATIFS HAUTE FREQUENCE

(30) Priorität: 04.01.2001 AT 192001
(43) Veröffentlichungstag der Anmeldung: 01.10.2003
(73) Patentinhaber: Lem Norma GmbH, 2345 Brunn am Gebirge (AT)
(72) Erfinder: TEPPAN, Wolfram, F-74160 Collonges sous Saleve (FR)
(74) Vertreter: Heger, Georg
(86) Internationale Anmeldenummer: PCT/AT2002/000001
(87) Internationale Veröffentlichungsnummer: WO 2002/054089

(56) Entgegenhaltungen:
- EP-A- 0 500 975
- EP-A- 0 500 976
- CA-A- 1 253 570
- DE-A- 3 611 595
- DE-A- 19 542 162
- FR-A- 2 079 959

## Beschreibung

Die Erfindung betrifft einen elektrischen Widerstand für die Messung hochfrequenter Wechselströme, mit Anschlüssen zum Einspeisen des Messstromes und Anschlüssen zum Abgriff der Messspannung und mit einem zumindest eine Widerstandsschicht einer Rückleitschicht und allfällige Isolierschichten aufweisenden Schichtaufbau.

Widerstände, die zum Messen von Strömen gedacht sind, werden als Nebenwiderstände, Nebenschlüsse oder Shunts bezeichnet. Sie sind ebenso wie Stromwandler einfache passive Stromsensoren, allerdings mit etwas anderen Eigenschaften. Verbreitet sind einerseits Bauformen für die Messung von Gleichströmen und andererseits extrem breitbandige Typen, die in der Lage sind, Ströme mit Frequenzen bis in den Gigahertzbereich zu messen. Bei Messwiderständen zur Messung besonders hochfrequenter Wechselströme muss darauf geachtet werden, dass die Induktivität des Shunts klein ist, und dass das unvermeidliche Restmagnetfeld den zu messenden Strom möglichst wenig beeinflusst. Zu diesem Zweck wird danach getrachtet, dass dieses Restmagnetfeld nicht nur mit dem zu messenden Strom, sondern auch mit dem Messkreis in einer Weise verkettet ist, dass die induktive Komponente der Spannung am Messabgriff aufghoben wird. Einfache drahtgewickelte Widerstände sind zum Messen von Wechselstrom aufgrund der hohen Induktivität der Spulenwicklung nicht geeignet.

Zur Reduktion der Induktivität von Messwiderständen sind auch bifilar aufgebaute Messwiderstände bekannt, bei welchen allerdings die aus dem Messwiderstand und den Messleitungen gebildete Schleife immer noch einen gewissen Teil des mit dem zu messenden Strom verketteten magnetischen Flusses umfasst.

Um die Schwierigkeiten bei bifilar gewickelten Messwiderständen zu überwinden, wurde auf koaxiale Anordnungen übergegangen, welche aus einem aus dünnem Widerstandsmaterial bestehenden Innenzylinder und einem normal leitenden Außenzylinder bestehen, wobei der zu messende Strom über den Innenleiter zugeführt und über den Außenleiter rückgeführt wird und der Spannungsabgriff, der sogenannte Kelvinabgriff, im inneren Zylinder im feldfreien Raum erfolgt und somit keine Induktion einer Spannung durch den Messstrom erfolgt. Derartige Koaxialwiderstände sind für hohe Ströme und Frequenzen bis in den Gigahertzbereich geeignet. Koaxialshunts haben zwar einen guten Frequenzgang, erfordern aber erheblichen Herstellungsaufwand und sind deshalb für viele Anwendungen zu teuer. Die tatsächliche Beschränkung der Bandbreite koaxialer Messwiderstände wird nicht durch die von Luftstreuflüssen in der Messschleife induzierten Spannungen, sondern durch Stromverdrängungserscheinungen im Inneren des Widerstandzylinders verusacht.

Beispielsweise beschreibt die US 5 596 309 A einen koaxialen Messwiderstand mit reduzierter Induktivität, bei dem zwischen dem inneren zylinderförmigen Widerstand und dem äußeren Zylinder ein Isolator, ebenfalls in zylindrischer Form, angeordnet ist, wodurch die Distanz zwischen dem äußeren Leiter und dem inneren Widerstand reduziert und somit der magnetische Streufluss vermindert werden kann. Neben der reduzierten Induktivität weist ein derartig aufgebauter Koaxialshunt bei geeignetem Widerstandsmaterial auch hohe Stabilität auf.

Neben den erwähnten koaxialen Messwiderständen sind auch sogenannte Scheibenwiderstände bekannt, bei welchen über einer aus Widerstandsmaterial angeordneten Scheibe eine Scheibe aus gut leitendem Material angeordnet ist. Durch eine koaxiale Anordnung der Stromzuführung und des Spannungsabgriffs kann die Induktivität reduziert werden, eine gewisse Restinduktivität bleibt jedoch immer erhalten. Derartige Scheibenwiderstände sind gegenüber koaxialen Messwiderständen zwar einfacher aufgebaut, zeigen jedoch immer noch hinsichtlich Herstellung und elektrischen Eigenschaften Nachteile.

Weiters sind Messwiderstände in Schichtanordnung bekannt, welche gegenüber den genannten Konstruktionen wesentlich einfacher und somit kostengünstiger herstellbar sind.

Ein derartiger Widerstand wird beispielsweise in der CA 1 253 570 A beschrieben, wobei leitfähige Schichten an den Außenseiten einer Leiterplatte angeordnet werden und durch entsprechende Durchkontaktierungen ein zwischen den beiden leitenden Schichten wechselnder Stromfluss stattfindet. Auf diese Weise wird eine Konstruktion geschaffen, welche gute elektrische Eigenschaften bei gleichzeitig niedrigen Herstellungskosten und einfachem Aufbau aufweist. Die in dem Pfad des zu messenden Stromes befindlichen Durchkontaktierungen bewirken eine Verschlechterung des Temperaturkoeffizienten. Die Verringerung des induktiven Anteils der Messspannung erfolgt durch eine Anordnung, durch die sich die Felder der einzelnen Leiterstücke im Bereich der Potenzialabgriffe aufheben sollen, ohne dass die Ausbreitung des Magnetfelds begrenzt wird.

Ein anderer durch Schichtenaufbau gebildeter elektrischer Widerstand für die Messung von hochfrequentem Wechselstrom, insbesondere mit Widerstandswerten im Milliohmbereich, ist in der DE 36 11 595 A1 beschrieben. Dieser Messwiderstand ist aus zwei Widerstandsfolien und äußeren Metallplatten gebildet, zwischen denen sich isolierende Klebefolien befinden. Zur elektrischen Verbindung der Widerstandsfolien untereinander bzw. mit den Metallplatten dienen streifenförmige Verbindungsschichten am Rand der Klebefolien. Ein derartig aufgebauter Messwiderstand kann relativ einfach hergestellt werden und ist somit im Vergleich zu Koaxialwiderständen wesentlich billiger. Dadurch können die Einsatzgebiete für derartige Messwiderstände, beispielsweise zur Überprüfung von schnellen Stromquellen oder Stromsenken, HF-Sendern, Frequenzumrichtern oder getakteten Netzteilen, bei denen Wechselströme bis zu einigen Hundert Ampere mit Frequenzen bis 100 MHz auftreten können, erweitert werden. Dadurch, dass die Ströme in der Widerstandsfolie und in den leitenden Metallplatten entgegengesetzt gerichtet sind und sich ihre etwa am gleichen Ort entstehenden Magnetfelder nahezu aufheben, erzeugt ein derartiger Widerstand nur ein entsprechend geringes Gesamtmagnetfeld. Allerdings treten an den Verbindungsschichten am Rand der Klebefolien immer noch Magnetfelder auf, welche eine geringe Induktivität des Messwiderstands bewirken und somit die Messgenauigkeit bzw. die Bandbreite des Widerstands beschränken. Die streifenförmigen Verbindungsschichten zur Verbindung der übereinander angeordneten Widerstandsschichten bewirken eine Verschlechterung des Temperaturkoeffizienten.

Ein Messwiderstand der gegenständlichen Art ist auch aus der EP 500 975 bekannt, wobei die Widerstandsschicht und die Rückleitschicht an einem Ende miteinander über Durchkontaktierungen verbunden sind und im anderen Endbereich mit den Potentialanschlüssen versehen sind. Diese Ausführungsform ist zwar gegenüber koaxialen Anordnungen wesentlich einfacher herstellbar, allerdings treten insbesondere in den Randbereichen des Messwiderstandes unerwünschte und das Messergebnis beeinflussende Magnetfelder auf.

Die Aufgabe der vorliegenden Erfindung besteht daher in der Schaffung eines elektrischen Messwiderstands der oben angegebenen Art, der möglichst gute elektrische Eigenschaften, wie geringe Induktivität, konstanten Frequenzgang und Phasenwinkel für möglichst hohe Bandbreite sowie eine hohe Langzeitstabilität, aufweist und möglichst einfach herstellbar ist. Darüber hinaus soll die Kühlung des Messwiderstands einfach und effizient möglich sein. Nachteile bekannter Messshunts sollen vermieden oder zumindest reduziert werden.

Gelöst wird die erfindungsgemäße Aufgabe dadurch, dass die Widerstandsschicht zusammen mit der Rückleitschicht und den allfälligen Isolierschichten Teil einer mehrschichtigen Leiterplatte ist und eine Mehrzahl von Leiterbahnen aufweist, die im. Wesentlichen konstante Breite und im Wesentlichen konstanten Abstand zueinander aufweisen und von einem mittigen Bereich der widerstandsschicht spiralförmig nach außen verlaufen. Durch einen derartigen kompakten Aufbau wird eine einfache Herstellbarkeit durch die in der Leiterplattenherstellung üblichen Multilayertechnologie ermöglicht, welche einfach automatisierbar ist. Weiters ist durch die kompakte Multilayeranordnung eine hohe Langzeitstabilität zu erwarten, da eine Korrosion durch äußere Einflüsse nahezu komplett unterbunden wird. Die von innen nach außen verlaufenden Leiterbahnen bewirken eine gleichmäßige Stromdichteverteilung und somit eine gleichmäßige Erwärmung. Die Rückleitschicht kann im einfachsten Fall aus einer durchgehenden Kupferschicht bestehen. Darüber hinaus können auch in der Rückleitschicht Leiterbahnen angeordnet sein.

Vorteilhafterweise weist die Rückleitschicht Leiterbahnen gleicher geometrischer Gestalt wie die Leiterbahnen der Widerstandsschicht auf. Dadurch werden sehr geringe unerwünschte Magnetfelder zugelassen, da die Ströme auf den Leiterbahnen der Widerstandsschicht in den Leiterbahnen der Rückleitschicht entgegengesetzt gerichtet sind und sich ihre etwa am gleichen Ort entstehenden Magnetfelder nahezu aufheben. Die entsprechenden beispielsweise spiralförmigen Leiterbahnen auf der Widerstandsschicht sowie der Rückleitschicht können in den bei der Leiterplattenherstellung üblichen Verfahren leicht und kostengünstig hergestellt werden.

Vorteilhafterweise sind die Widerstandsschicht sowie die Rückleitschicht in Draufsicht im Wesentlichen kreisförmig. Dadurch werden kreissymmetrische Verhältnisse erzielt.

Gemäß einem weiteren Merkmal der Erfindung ist vorgesehen, dass auch die Leiterbahnen der Rückleitschicht im Wesentlichen konstante Breite und im Wesentlichen konstanten Abstand zueinander aufweisen. Eine derartige geometrische Gestalt verstärkt den technischen Effekt der konstanten Stromdichteverteilung über die Widerstandsschicht und somit der gleichmäßigen Erwärmung.

Die konstante Stromdichteverteilung wird insbesondere auch durch vom mittigen Bereich nach außen spiralförmig verlaufende Leiterbahnen der Rückleitschicht erzielt. Je nach Anzahl der vom Zentrum der Widerstandsschicht und Rückleitschicht nach außen verlaufenden Leiterbahnen kann durch entsprechende mathematische Methoden die geeignete Art der Spiralenform berechnet werden.

Gemäß einem weiteren Merkmal der Erfindung ist vorgesehen, dass die Anschlüsse zum Einspeisen des Messstromes und bzw. oder die Anschlüsse zum Abgriff der Messspannung durch entsprechende Durchkontaktierungen, sogenannte Vias, an die gewünschte Schicht geführt werden. Dadurch werden Zuleitungen verhindert, in welchen unerwünschte Spannungen induziert werden könnten, die den zu messenden Strom verfälschen würden. Der zwischen der Widerstandsschicht und der Rückleitungsschicht verbleibende magnetische Fluss ist mit dem über den Kelvinabgriff gemessenen Strom nicht verkettet und leistet daher keinen Beitrag zum Messsignal.

Vorteilhafterweise besteht zumindest eine Isolierschicht aus einer oder mehreren Prepreg-Lagen, vorzugsweise mit einer Dicke von weniger als 0,1 mm.

Wenn die Widerstandsschicht zwischen der Rückleitschicht und einer die Anschlüsse zum Abgriff der Messspannung enthaltenden Anschlussschicht angeordnet ist, kann eine Verkettung des magnetischen Flusses des zu messenden Stromes mit den Leitern des Kelvinabgriffs weitgehend verhindert werden.

Eine sehr gute Abführung der Verlustwärme ist dadurch gegeben, dass die Isolierschicht zwischen der Rückleitschicht und einem allfälligen Kühlkörper aus Lötstopplack oder Lötstoppfolie besteht und somit sehr dünn ist.

Die Erfindung wird anhand von Zeichnungen, welche ein Ausführungsbeispiel der Erfindung zeigen, noch weiter erläutert. Darin zeigen:
Fig. 1 ein schematisches Schaltbild zur Veranschaulichung der Anschlüsse des Messwiderstands,
Fig. 2 eine perspektivische Explosionsdarstellung eines Messwiderstands gemäß der vorliegenden Erfindung,
Fig. 3a bis 3f Draufsichten auf die verschiedenen Schichten des Messwiderstands gemäß Fig. 2, und
Fig. 4 einen schematischen Querschnitt durch den Schichtaufbau des vorliegenden Messwiderstands zur Veranschaulichung der Dickenverhältnisse.

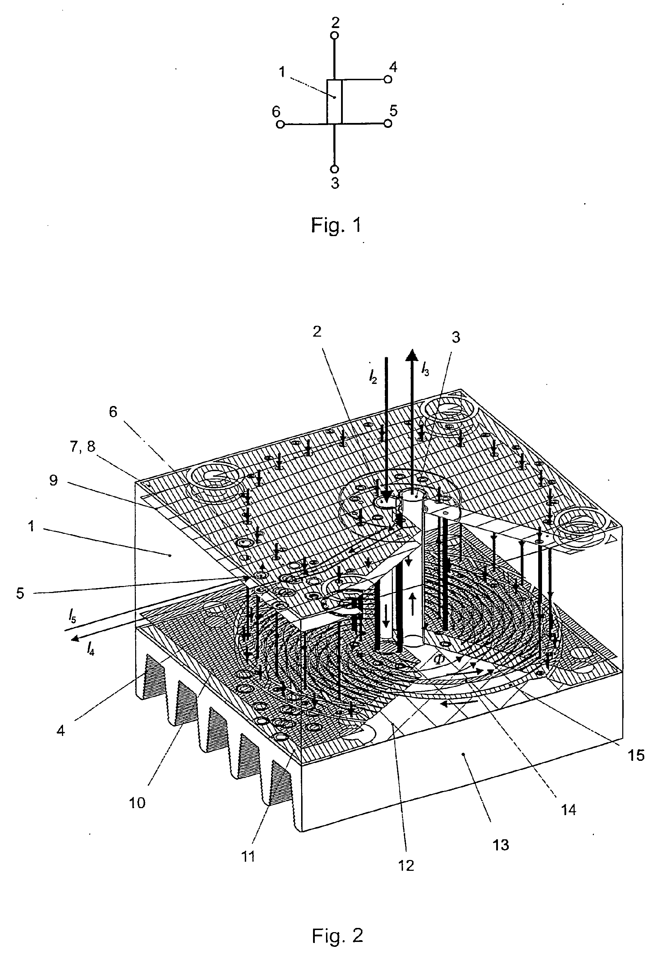

Fig. 1 zeigt ein Ersatzschaltbild eines Messwiderstands 1 mit einem Schema der Anschlüsse. Über Anschlüsse 2, 3 wird der zu messende Strom durch den Messwiderstand 1 geleitet und über Anschlüsse 4, 5 (Kelvinanschlüsse) wird die zu messende Spannung abgegriffen. Der Anschluss 6 dient zum Anschluss eines Schirms für den Kelvinabgriff.

In Fig. 2 ist der erfindungsgemäß in einem Schichtaufbau hergestellte Messwiderstand 1 dargestellt. Bei den Schichten handelt es sich um die Widerstandsschicht 10, die Rückleitschicht 11, eine Verbindungsschicht 9 und eine Anschlussschicht 8 sowie Lötstoppschichten 7 und 12. Die einzelnen Schichten 7, 8, 9, 10, 11 und 12 sind für eine bessere Darstellbarkeit auseinandergezogen und teilweise geschnitten dargestellt. Der zu messende Strom wird über die Anschlüsse 2 und 3 in den Messwiderstand 1 ein- und von diesem wieder zurückgeleitet. Die Anschlüsse 2 und 3 befinden sich im Zentrum des Messwiderstandes 1 und werden zur Rückleitschicht 11 bzw. der Widerstandsschicht 10 entsprechend durchkontaktiert. Der Spannungsabgriff erfolgt über die Anschlüsse 4, 5 in der Anschlussschicht 8. Ein Kühlkörper 13 ist vorzugsweise unter der Rückleitschicht 11 angeordnet, beispielsweise verklebt oder verschraubt, wobei eine Isolierung, vorzugsweise durch die aus Lötstopplack bestehende Isolierschicht 12, die auf die Rückleitschicht 11 aufgetragen wird, vorgesehen sein kann. In der Widerstandsschicht 10 fließt der Strom entlang von spiralförmigen Leiterbahnen 14 von innen nach außen und in der Rückleitschicht 11 entlang gleichgestalteter Leiterbahnen 15 von außen nach innen zurück zum Anschluss 3 des Messwiderstands 1. Von der Widerstandsschicht 10 führen an der Außenseite entsprechende Durchkontaktierungen 18 zur Außenseite der Rückleitschicht 11. Alle Anschlüsse 2, 3, 4, 5, 6 bestehen in der Leiterplatte aus metallisierten Bohrungen. In der Verbindungsschicht 9, welche wie die Anschlussschicht 8 und die Rückleitschicht 11 vorzugsweise aus Kupfer besteht, wird ein Teil des zu messenden Stromes auf die Durchkontaktierungen 16 aufgeteilt, um die Stromdichte nach dem Eintritt in die Widerstandsschicht 10 zu begrenzen. Die Verbindung zum Anschluss 4 besteht aus den Durchkontaktierungen 17 und der Leiterbahn in der Anschlussschicht 8. Über die Durchkontaktierungen 19 und die äußere leitende Fläche der Anschlussschicht 8 erfolgt die Verbindung des Kelvinanschlusses 5 mit der Widerstandsschicht 10. Der zu messende Strom gelangt über die Durchkontaktierungen 18 zu den äußeren Enden der Leiterbahnen 15 in der Rückleitschicht 11. Über die Durchkontaktierungen 18 erfolgt auch eine Verbindung der Widerstandsschicht 10 mit der Verbindungsschicht 9, welche zum Anschluss 6 führt. Diese Kupferschicht 9 dient auch als Schirm für den Kelvinabgriff in seinem Verlauf auf der Leiterplatte.

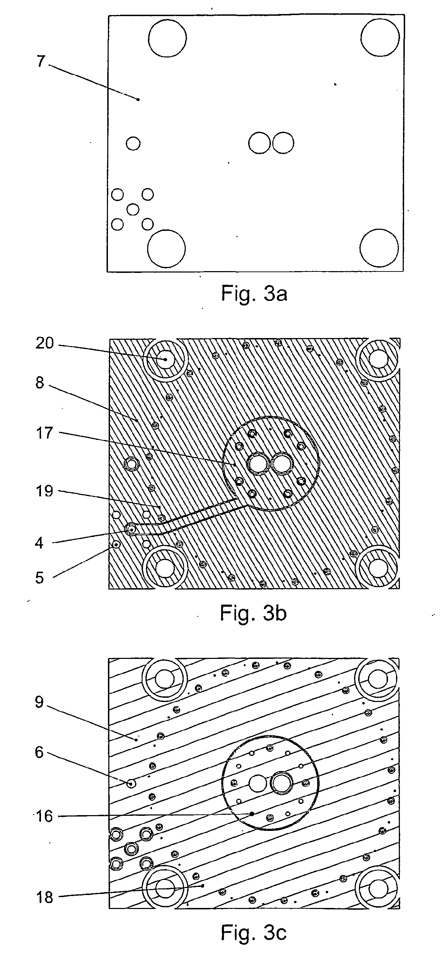

Fig. 3a zeigt die gemäß Fig. 2 transparent dargestellte oberste Isolierschicht 7 des Messwiderstands 1, welcher die Lötstoppmaske repräsentiert. An Stellen der Anschlüsse 2, 3 für den zu messenden Strom und der Anschlüsse 4, 5 für den Spannungsabgriff sowie des Anschlusses 6 für den Schirm sowie an Stellen allfälliger Bohrungen 20 für Befestigungselemente ist die Isolierschicht 7 (Lötstopplack) freigestellt.

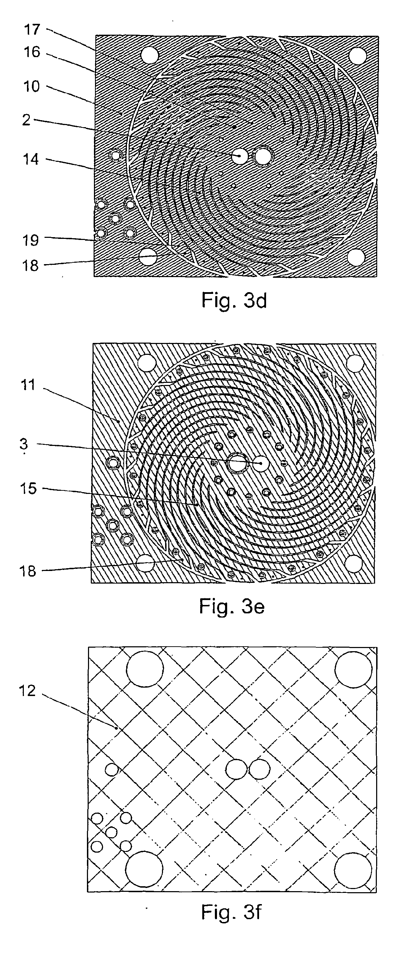

Fig. 3b zeigt die Anschlussschicht 8, welche die Verbindung vom Kelvinanschluss 4 in das Zentrum der Schicht darstellt, wo eine Verbindung über die Durchkontaktierungen 17 zur Widerstandsschicht 10 entsprechend Fig. 3d erfolgt.

Fig. 3c zeigt die Verbindungsschicht 9, welche beispielsweise aus Kupfer besteht und eine Verbindung des Anschlusses 2 mit der darunter liegenden Widerstandsschicht 10 über die Durchkontaktierungen 16 bewerkstelligt.

Fig. 3d zeigt die Widerstandsschicht 10 des Messwiderstands 1, welche vorzugsweise aus einer Legierung mit niedrigem Temperaturkoeffizienten gebildet ist. Die Abbildung zeigt deutlich die spiralförmigen Leiterbahnen 14, welche im Wesentlichen konstanten Abstand zueinander und im Wesentlichen konstante Breite aufweisen. Im dargestellten Beispiel weist die Widerstandsschicht 10 insgesamt 24 spiralförmig nach außen verlaufende Leiterbahnen 14 auf. Diese Anzahl kann entsprechend verändert werden, wobei eine gewisse Mindestanzahl zur Erreichung symmetrischer Verhältnisse erforderlich ist. Durch die im Wesentlichen konstante Breite der Leiterbahnen 14 wird eine konstante Stromdichteverteilung über die Widerstandsschicht 10 und somit eine konstante Erwärmung erzielt.

Fig. 3e zeigt die unter der Widerstandsschicht 10 angeordnete Rückleitschicht 11, welche gleiche geometrische Gestalt wie die Widerstandsschicht 10 aufweist, so dass sich die durch die in der Widerstandsschicht 10 und in der Rückleitschicht 11 fließenden Ströme hervorgerufenen Magnetfelder einander weitgehend aufheben.

Fig. 3f zeigt die vorzugsweise aus Lötstopplack bestehende Isolierschicht 12 mit gleicher geometrischer Gestalt wie die Isolierschicht 7 (siehe Fig. 3a), welche die Rückleitschicht 11 vom Kühlkörper 13 isoliert.

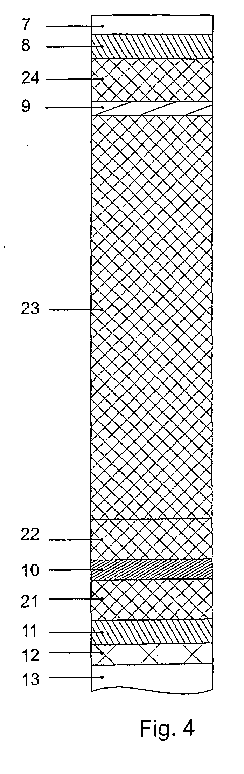

Fig. 4 zeigt schließlich ein Schema eines Querschnitts des erfindungsgemäßen Messwiderstands 1 zur Veranschaulichung der Dimensionsverhältnisse. Oberhalb des Kühlkörpers 13 ist eine auf der Unterseite der Rückleitschicht 11 angeordnete Isolierschicht 12 aus Lötstopplack angeordnet. Die Isolierschicht 12 hat beispielsweise eine Dicke von 50 µm, während die Rückleitschicht 11 aus 60 µm Kupfer bestehen kann. Zwischen der Widerstandsschicht 10 und der Rückleitschicht 11 ist eine Isolierschicht 21, beispielsweise aus einer oder zwei Prepreg-Lagen, mit jeweils 50 µm Dicke angeordnet. Die Widerstandsschicht 10 kann beispielsweise aus 50 µm Zeranin bestehen. Die Widerstandsschicht 10 ist mit Hilfe einer Isolierschicht 22 aus einer oder mehreren Prepreg-Lagen auf ein Stück einlagiges Leiterplattenbasismaterial, bestehend aus der Isolierschicht 23 und der Verbindungsschicht 9, auflaminiert, wobei die Isolierschicht 23 beispielsweise 1 mm und die Verbindungsschicht 9 beispielsweise 30 µm stark sein kann. Zwischen der Anschlussschicht 8, welche ebenfalls aus beispielsweise 60 µm Kupfer bestehen kann, und der Verbindungsschicht 9 sind wiederum eine oder mehrere Prepreg-Lagen mit beispielsweise 100µm Dicke zur Bildung der Isolierschicht 24 angeordnet. Über der Anschlussschicht 8 ist schließlich eine weitere Isolierschicht 7 (siehe Fig. 3a) aus beispielsweise 50 µm Lötstopplack angeordnet.

An Stelle der dargestellten Ausführungsbeispiele können auch weitere im Rahmen der vorliegenden Erfindung abgeänderte Varianten vorgesehen sein.

## Patentansprüche

1. Elektrischer Messwiderstand (1) zur Messung hochfrequenter Wechselströme, mit Anschlüssen (2, 3) zum Einspeisen des Messstromes und Anschlüssen (4, 5) zum Abgriff der Messspannung und mit einem zumindest eine Widerstandsschicht (10), eine Rückleitschicht (11) und allfällige Isolierschichten (7, 12, 21, 22, 23, 24) aufweisenden Schichtaufbau, **dadurch gekennzeichnet, dass** die Widerstandsschicht (10) zusammen mit der Rückleitschicht (11) und den allfälligen Isolierschichten (7, 12, 21, 22, 23, 24) Teil einer mehrschichtigen Leiterplatte ist und eine Mehrzahl von Leiterbahnen (14) aufweist, die im Wesentlichen konstante Breite und im Wesentlichen konstanten Abstand zueinander aufweisen und von einem mittigen Bereich der Widerstandsschicht (10) spiralförmig nach außen verlaufen.

2. Messwiderstand nach Anspruch 1, **dadurch gekennzeichnet, dass** die Rückleitschicht (11) Leiterbahnen (15) gleicher geometrischer Gestalt wie die Leiterbahnen (14) der Widerstandsschicht (10) aufweist.

3. Messwiderstand nach Anspruch 1 oder 2, **dadurch gekennzeichnet, dass** die Widerstandsschicht (10) und die Rückleitschicht (11) in Draufsicht im Wesentlichen kreisförmig sind.

4. Messwiderstand nach einem der ansprüche 1 bis 3, **dadurch gekennzeichnet, dass** die Leiterbahnen (15) der Rückleitschicht (11) im Wesentlichen konstante Breite und im Wesentlichen konstanten Abstand zueinander aufweisen.

5. Messwiderstand nach Anspruch 4, **dadurch gekennzeichnet, dass** die Leiterbahnen (15) der Rückleitschicht (11) vom mittigen Bereich spiralförmig nach außen verlaufen.

6. Messwiderstand nach einem der Ansprüche 1 bis 5, **dadurch gekennzeichnet, dass** die Anschlüsse (2, 3) zum Einspeisen des Messstromes und bzw. oder die Anschlüsse (4, 5) zum Abgriff der Messspannung durch entsprechende Durchkontaktierungen (16, 17, 18, 19) an die gewünschten Schichten (8, 10, 11) geführt werden.

7. Messwiderstand nach einem der Ansprüche 1 bis 6, **dadurch gekennzeichnet, dass** zumindest eine Isolierschicht (21, 22, 23, 24) aus einer oder mehreren Prepreg-Lagen, vorzugsweise mit einer Dicke von weniger als 0,1 mm besteht.

8. Messwiderstand nach einem der Ansprüche 1 bis 7, **dadurch gekennzeichnet, dass** die Widerstandsschicht (10) zwischen der Rückleitschicht (11) und einer die Anschlüsse (4, 5) zum Abgriff der Messspannung enthaltenden Anschlussschicht (8) angeordnet ist.

9. Messwiderstand nach einem der Ansprüche 1 bis 8, **dadurch gekennzeichnet, dass** die Isolierschicht (12) zwischen der Rückleitschicht (11) und einem allfälligen Kühlkörper (13) aus Lötstopplack oder Lötstoppfolie besteht.

## Claims

1. An electrical measurement resistor (1) for measuring alternating currents of high frequency, comprising connectors (2, 3) for feeding the current to be measured and connectors (4, 5) for tapping the voltage to be measured, and having a layered structure including at least one resistive layer (10), a return conducting layer (11), and any possibly provided insulating layers (7, 12, 21, 22, 23, 24), **characterized in that** the resistive layer (10) together with the return conducting layer (11) and the possibly provided insulating layers (7, 12, 21, 22, 23, 24) is part of a multilayered printed circuit board and comprises a plurality of conductive tracks (14) having a substantially constant width and a substantially constant distance from each other, and extending spirally outwards from a central region of the resistive layer (10).

2. The measurement resistor according to claim 1, **characterized in that** the return conducting layer (11) comprises conductive tracks (15) of the same geometrical shape as the conductive tracks (14) of the resistive layer (10).

3. The measurement resistor according to claim 1 or 2, **characterized in that** the resistive layer (10) and the return conducting layer (11) are substantially circular in top view.

4. The measurement resistor according to any one of claims 1 to 3, **characterized in that** the conductive tracks (15) of the return conducting layer (11) have a substantially constant width and a substantially constant distance from each other.

5. The measurement resistor according to claim 4, **characterized in that** the conductive tracks (15) of the return conducting layer (11) extend spirally outwards from the central region.

6. The measurement resistor according to any one of claims 1 to 5, **characterized in that** the connectors (2, 3) for feeding the current to be measured and/or the connectors (4, 5) for tapping the voltage to be measured are led to the desired layers (8, 10, 11) through respective feed-throughs (16, 17, 18, 19).

7. The measurement resistor according to any one of claims 1 to 6, **characterized in that** at least one insulating layer (21, 22, 23, 24) consists of one or more prepreg layers, preferably having a thickness of less than 0.1 mm.

8. The measurement resistor according to any one of claims 1 to 7, **characterized in that** the resistive layer (10) is arranged between the return conducting layer (11) and a connector layer (8) containing the connectors (4, 5) for tapping the voltage to be measured.

9. The measurement resistor according to any one of claims 1 to 8, **characterized in that** the insulating layer (12) provided between the return conducting layer (11) and a possibly present cooling body (13) is made of solder resist or solder stop film.

## Revendications

1. Résistance de mesure électrique (1) pour mesurer des courants alternatifs haute fréquence, avec des bornes (2, 3) pour injecter le courant de mesure et des bornes (4, 5) pour prélever la tension à mesurer, et avec une construction en couches présentant au moins une couche de résistance (10), une couche de retour (11) et des couches d'isolation éventuelles (7, 12, 21, 22, 23, 24), **caractérisée en ce que** la couche de résistance (10), en conjonction avec la couche de retour (11) et les couches d'isolation éventuelles (7, 12, 21, 22, 23, 24) fait partie d'une carte de circuits imprimés multicouche et présente une pluralité de pistes conductives (14) qui présentent une largeur substantiellement constante et un espacement mutuel substantiellement constant et s'étendent à partir d'une zone centrale de la couche de résistance (10) en spirale vers l'extérieur.

2. Résistance de mesure selon la revendication 1, **caractérisée en ce que** la couche de retour (11) présente des pistes conductives (15) de la même forme géométrique que les pistes conductives (14) de la couche de résistance (10).

3. Résistance de mesure selon la revendication 1 ou 2, **caractérisée en ce que** la couche de résistance (10) et la couche de retour (11) sont substantiellement circulaires en vue de dessus.

4. Résistance de mesure selon l'une quelconque des revendications 1 à 3, **caractérisée en ce que** les pistes conductives (15) de la couche de retour (11) présentent une largeur substantiellement constante et un espacement mutuel substantiellement constant.

5. Résistance de mesure selon la revendication 4, **caractérisée en ce que** les pistes conductives (15) de la couche de retour (11) s'étendent à partir de la zone centrale en spirale vers l'extérieur.

6. Résistance de mesure selon l'une quelconque des revendications 1 à 5, **caractérisée en ce que** les bornes (2, 3) pour injecter le courant de mesure et/ou les bornes (4, 5) pour prélever la tension de mesure sont amenées aux couches souhaitées (8, 10, 11) à travers des trous métallisés (16, 17, 18, 19) correspondants.

7. Résistance de mesure selon l'une quelconque des revendications 1 à 6, **caractérisée en ce qu'**au moins une couche d'isolation (21, 22, 23, 24) se compose d'une ou de plusieurs couches de feuille préimprégnée, de préférence d'une épaisseur de moins de 0,1 mm.

8. Résistance de mesure selon l'une quelconque des revendications 1 à 7, **caractérisée en ce que** la couche de résistance (10) est disposée entre la couche de retour (11) et une couche de connexion (8) comprenant les bornes (4, 5) pour prélever la tension à mesurer.

9. Résistance de mesure selon l'une quelconque des revendications 1 à 8, **caractérisée en ce que** la couche d'isolation (12) entre la couche de retour (11) et un corps isolant éventuel (13) se compose d'un vernis ou d'un film d'arrêt de brasage.
